(19) Europäisches Patentamt
European Patent Office
Office européen des brevets

(11) **EP 1 901 336 B1**

(12) **EUROPEAN PATENT SPECIFICATION**

(45) Date of publication and mention
of the grant of the patent:
**11.01.2012 Bulletin 2012/02**

(51) Int Cl.:
***H01L 21/027*** (2006.01)     ***G03F 7/20*** (2006.01)

(21) Application number: **06732588.6**

(86) International application number:
**PCT/JP2006/309657**

(22) Date of filing: **15.05.2006**

(87) International publication number:
**WO 2007/004358 (11.01.2007 Gazette 2007/02)**

(54) **EXPOSURE APPARATUS**

BELICHTUNGSVORRICHTUNG

DISPOSITIF D'EXPOSITION

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **06.07.2005 JP 2005197031**

(43) Date of publication of application:
**19.03.2008 Bulletin 2008/12**

(73) Proprietor: **NIKON CORPORATION
Chiyoda-ku
Tokyo 100-8331 (JP)**

(72) Inventor: **SHIRAISHI Masayuki
Tokyo 1008331 (JP)**

(74) Representative: **Viering, Jentschura & Partner
Postfach 22 14 43
80504 München (DE)**

(56) References cited:
**JP-A- 2000 131 439      JP-A- 2004 146 822
JP-A- 2005 069 854      JP-A- 2006 114 914
US-A1- 2002 041 368      US-A1- 2005 045 829**

## Description

*TECHNICAL FIELD*

The present invention relates to an exposure apparatus applied to a photolithography, such as to an exposure apparatus for extreme ultra violet lithography (EUVL) using an exposure wavelength of 50 nm or less.

*BACKGROUND ART*

An ordinary exposure apparatus is equipped with light-quantity sensors for monitoring fluctuations in the light quantity of exposure light (see patent documents 1 and 2, etc.). In particular, in patent document 1, a system (lens adjusting system) is disclosed which arranges light-quantity sensors on an upstream side and a downstream side of a projection optical system, estimates fluctuation amounts of the characteristics of the projection optical system based on the outputs of the light-quantity sensors, and adjusts the projection optical system so as to control the fluctuation amounts. It is desirable that such an adjusting system be incorporated also in an exposure apparatus for EUVL which is a next-generation exposure apparatus.
Patent Document 1: Japanese Unexamined Patent Application Publication No. Hei9-36018
Patent Document 2: Japanese Unexamined Patent Application Publication No. Heil1-16816
Document US2002/0041368 A1 discloses an exposure apparatus. The apparatus uses a wide bandwidth light source that produces exposure light and non-exposure light. An optical adjustment of the exposure apparatus is performed by using the exposure light and non-exposure light.

*DISCLOSURE OF THE INVENTION*

*PROBLEMS TO BE SOL VED BY THE INVENTION*

However, the inventors of the present invention have found out that there is a possibility that the adjusting system does not operate normally when it is applied to an exposure apparatus for EUVL as it is. The reason is that a special light source for EUVL (EUV light source) is used in an exposure apparatus for EUVL, a special mirror for reflecting EUV light (reflecting mirror having a multilayered film) is used, and the like. In that case, it can be considered that it is difficult to estimate fluctuation amounts of the characteristics of a projection optical system from fluctuations in the light quantity of exposure light.
It is therefore an object of the present invention to provide an exposure apparatus capable of accurately grasping characteristic fluctuations of an optical system caused by irradiation heat of light.

*MEANS FOR SOL VIMG THE PROBLEMS*

First, the inventors of the present invention took the following circumstances peculiar to an exposure apparatus for EUV into consideration.

[1] From an EUV light source, non-exposure wavelength components (out-band light) are emitted in addition to exposure wavelength components (in-band light) (the exposure wavelength components are EUV light, and the non-exposure wavelength components are extra ultraviolet light, visible light, infrared light, etc.).
[2] It has been also studied to insert filters blocking out-band light. However, the filters must be inserted on the upstream as far as possible (on the upstream than an integrator of the illumination optical system). In that case, the filters are exposed to EUV light having a relatively large light quantity, so that a durability problem arises.
[3] A reflecting mirror having a multilayered film used in many optical systems for EUVL reflects not only in-band light but also out-band light.
[4] There is a high possibility that the fight-quantity ratio between in-band light and out-band light fluctuates according to the operation status of an EUV light source.

In view of the above circumstances, it is understood that at least it is necessary to detect in-band light and out-band light independently in order to accurately grasp characteristic fluctuations of an optical system for EUVL.
For this purpose, the exposure apparatus of the present invention is characterized in that an exposure apparatus exposing an object to be exposed with light emitted from a light source includes a detecting unit detecting light quantity of non-exposure wavelength component of the light.
The detecting unit preferably detects light quantity of exposure wavelength component of the light and light quantity of non-exposure wavelength component of the light independently.

Furthermore, any of the exposure apparatuses of the present invention preferably includes a projection optical system arranged between the light source and the object to be exposed, and an adjusting unit adjusting the projection optical system based on an output of the detecting unit.

Furthermore, the projection optical system preferably includes at least one mirror, and at least one of subjects of to be adjusted by the adjusting unit is preferably a position of the mirror in a direction perpendicular to an optical axis.

Furthermore, the projection optical system preferably includes at least one mirror, and at least one of subjects to be adjusted by the adjusting unit is preferably an attitude of the mirror.

Furthermore, the projection optical system preferably projects a pattern of a mask arranged on the light source side onto the object to be exposed, and at least one of subjects to be adjusted by the adjusting unit is preferably a relative position between the mask and the object to be exposed.

Furthermore, the projection optical system preferably projects a pattern of a mask arranged on the light source side onto the object to be exposed, and at least one of subjects to be adjusted by the adjusting unit is preferably an attitude of at least one of the mask and the object to be exposed.

Furthermore, the detecting unit preferably detects light quantity of exposure wavelength component of the light and light quantity of non-exposure wavelength component of the light independently, and the adjusting unit preferably determines, to carry out the adjusting, adjustment contents of the projection optical system based on light quantity of the exposure wavelength component, light quantity of the non-exposure wavelength component, characteristic information of the projection optical system for the exposure wavelength component, and characteristic information of the projection optical system for the non-exposure wavelength component.

Furthermore, the detecting unit preferably includes at least two of the detecting units, which are a first detecting unit whose detecting object is the light before passing the projection optical system, and a second detecting unit whose detecting object is the tight after passing the projection optical system, and the adjusting unit preferably corrects characteristic information of the projection optical system for the exposure wavelength component based on light quantity of the exposure wavelength component detected by the first detecting unit and light quantity of the exposure wavelength component detected by the second detecting unit, and characteristic information of the projection optical system for the non-exposure wavelength component based on light quantity of the non-exposure wavelength component detected by the second detecting unit and light quantity of the non-exposure wavelength component detected by the second detecting unit.

Furthermore, characteristic information of the projection optical system preferably includes each of absorption coefficients of optical members in the projection optical system.

Furthermore, the adjusting unit preferably reflects information about reflectivity of the object to be exposed for the non-exposure wavelength component into the adjustment contents.

Furthermore, any of the exposure apparatuses of the present invention may further include a detecting unit detecting reflectivity of the object to be exposed for the non-exposure wavelength component.

Furthermore, the detecting unit may include a sensor for exposure wavelength detecting light quantity of exposure wavelength component of the light, and a sensor for non-exposure wavelength detecting light quantity of non-exposure wavelength component of the light.

Furthermore, the detecting unit may include a sensor for specific wavelength detecting light quantity of exposure wavelength component or non-exposure wavelength component of the light, and a sensor for all wavelengths detecting light quantity of all wavelength components of the light.

Furthermore, the detecting unit may include a sensor for all wavelengths capable of detecting light quantity of all wavelength components of the light, and a switching unit switching wavelength of incident light on the sensor for all wavelengths between at least two of exposure wavelength, non-exposure wavelength, and all wavelengths.

Furthermore, the light source may be an EUV light source.

EFFECT OF THE INVENTION

According to the present invention, an exposure apparatus capable of accurately grasping characteristic fluctuations of an optical system caused by irradiation heat of light is realized.

BRIEF DESCRIPTION OF THE DRAWINGS

Fig. 1 is a schematic configuration diagram of a projection exposure apparatus of the first embodiment;
Fig. 2 illustrates in detail where light-quantity sensors 12 and 13 are arranged;
Figs. 3(a) and 3(b) illustrate the configurations and detectable wavelength bands of light-quantity sensors 12 and 13;
Fig. 4 is a flow chart of the operation of a controlling part 9 regarding a mirror adjusting system;

Figs. 5(a) to 5(c) illustrate step S2;

Fig. 6 illustrates step S3;

Fig. 7 shows an example having two or more tight-quantity sensors 12 and 13;

Fig. 8 is a schematic configuration diagram of a projection exposure apparatus of a second embodiment;

Fig. 9 illustrates a variation of a sensor part;

Fig. 10 illustrates another variation of a sensor part;

Fig. 11 illustrates still another variation of a sensor part;

Fig. 12 illustrates the degree of freedom of stages of a third embodiment;

Figs. 13(A) and 13(B) illustrate a method of determining adjusting amounts of the third embodiment; and

Figs. 14(A) and 14(B) illustrate a method of calculating heat-absorption amounts of a fourth embodiment.

*BEST MODE FOR CARRYING OUT THE INVENTION*

[First Embodiment]

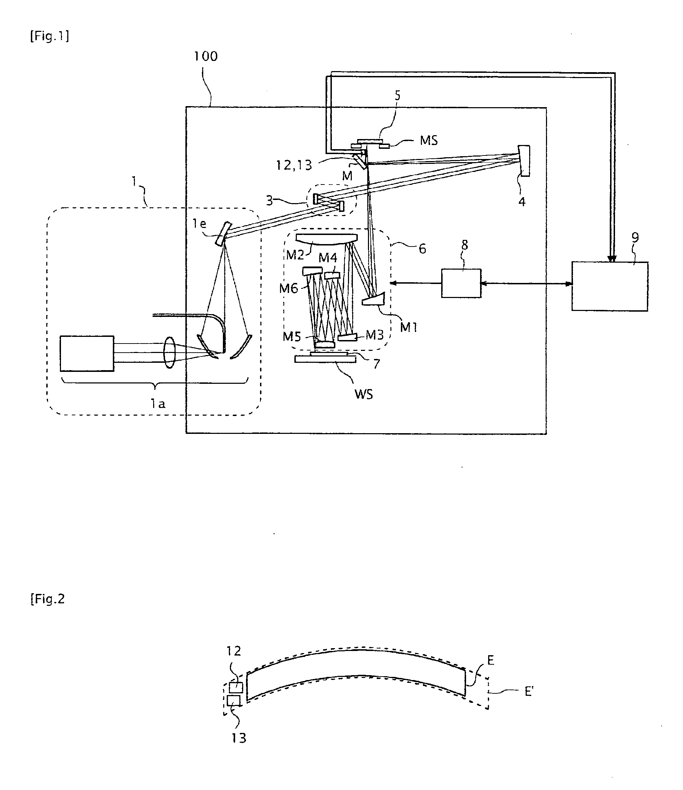

The first embodiment of the present invention will be described below with reference to Fig.1, 2, 3, 4, 5, 6, and 7. This embodiment is an embodiment of a projection exposure apparatus for EUVL.

First, the configuration of the projection exposure apparatus will be described.

Fig. 1 is a schematic configuration diagram of the projection exposure apparatus. As shown in Fig. 1, in the projection exposure apparatus, an irradiating apparatus 1, an integrator of reflecting type 3, a condenser mirror 4, an optical path bending mirror M, a reticle of reflecting type 5, a reticle stage MS, a projection optical system of reflecting type 6, a wafer 7, a wafer stage WS, a mirror adjusting mechanism 8, fight-quantity sensors 12 and 13, etc. are arranged, and the driving portions of them are connected with a controlling part 9 consisting of a circuit, a computer, etc. The reference numeral 100 in Fig. 1 denotes a vacuum chamber for keeping all of the optical paths of the projection exposure apparatus in a vacuum.

The irradiating apparatus 1 is equipped with a laser plasma light source 1 a which is a kind of an EUV light source, and a collimator mirror 1e. From the laser plasma light source 1 a, EUV light of the wavelength of 13.5 nm which is in-band light, and out-band light of the other wavelengths are emitted.

Light emitted from the laser plasma light source la passes through the collimator mirror 1e, the integrator 3, the condenser mirror 4, and the optical path bending mirror M in this order, and then illuminates the region to be illuminated of the reticle 5 evenly. Light reflected by the region to be illuminated of the reticle 5 enters the projection optical system 6.

In the projection optical system 6, a pluraliy of mirrors, such as six mirrors M1, M2, M3, M4, M5, and M6 are arranged. Light reflected by the mirror M1, M2, M3, M4, M5, and M6 forms a reduced image of the reticle 5 on the wafer 7. The reduced image is a reduced image of a pattern formed in the region to be illuminated of the reticle 5. By the reduced image, a region to be exposed on the surface of the wafer 7 is exposed.

Distances between the mirrors M1, M2, M3, M4, M5, and M6 (positions in the optical axis directions of respective mirrors) in the projection optical system 6 can be adjusted by the mirror adjusting mechanism 8. An instruction for the adjustment and adjusting amounts (adjusting amounts of respective mirrors in the optical axis directions) are given from the controlling part 9 to the mirror adjusting mechanism 8. Thus, the image-forming characteristic of the projection optical system 6 can be adjusted. Here, to each of the optical systems in the projection exposure apparatus, a characteristic for reflecting in-band light (here, EUV light of the wavelength of 13.5 nm) has been added. In particular, each of the mirrors in the integrator 3, the condenser mirror 4, the optical path bending mirror M, and each of the mirrors M1, M2, M3, M4, M5, and M6 in the projection optical system 6, shown in Fig. 1, are direct incidence type mirrors the light incidence angles of which are less than 45 degrees, so that a multilayered film is formed on the reflecting surface of each of the mirrors. The multilayered film is formed by stacking two or more materials of, for example, molybdenum (Mo), silicon (Si), ruthenium (Ru), rhodium (Rh), silicon oxides, and the like. The reflectivity of a mirror on which such a multilayered film is formed is, for example, the order of about 60 to 70 % for in-band light, and the order of about 80 % for out-band light.

Next, the fight-quantity sensors 12 and 13 will be described in detail.

As shown in Fig. 1, arrangement places of the iight-quantity sensors 12 and 13 are in a luminous flux illuminating the reticle 5. The arrangement places are shown in detail in Fig. 2. In Fig. 2, the symbol E' denotes a region to be illuminated of the reticle 5, and the symbol E denotes a transfer region of the reticle 5 (the transfer region is a region which is projected onto the wafer 7). The region to be illuminated E' covers the whole of the transfer region E and is slightly larger than the transfer region E. The light-quantity sensors 12 and 13 are to be arranged in the luminous flux illuminating the region to be illuminated E' and incidents on the outside of the transfer region E. The light-quantity sensors 12 and 13 arranged in this place are able to monitor the light quantity of a luminous flux going to the wafer 7 without influencing the luminous flux.

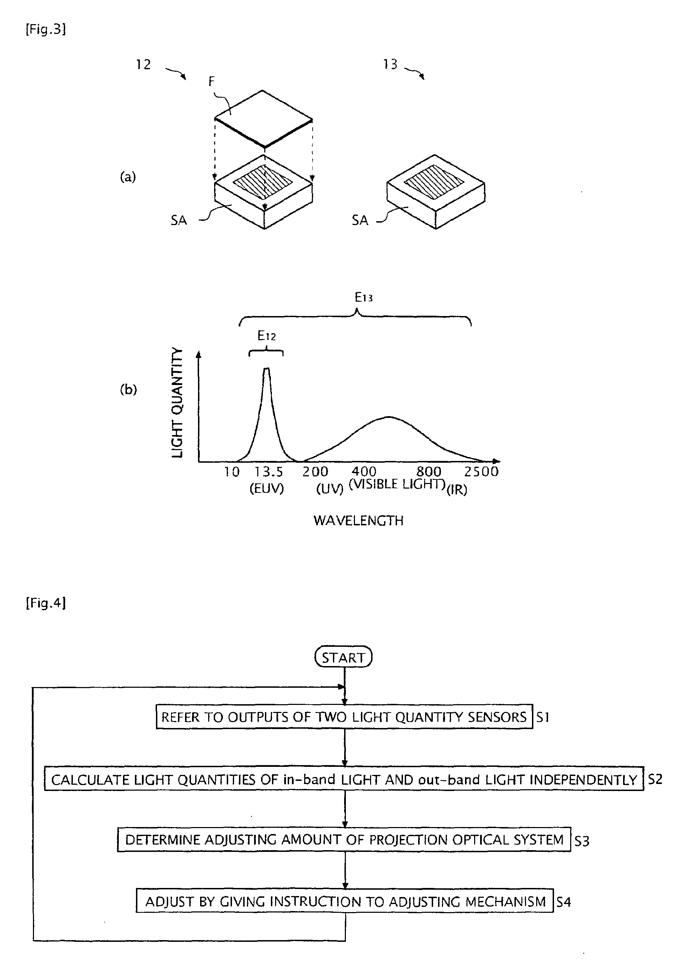

Figs. 3(a) and 3(b) illustrate the configurations and detectable wavelength bands of the light-quantity sensors 12 and 13.

First, as shown on the left side of Fig. 3(a), the light-quantity sensor 12 has a wavelength-selecting filter F provided on a photoelectric conversion element SA. The photoelectric conversion element SA is a photoelectric conversion element which consists of a silicon photodiode, etc., and senses light of a sufficiently wide wavelength band. The wavelength band sensed by the photoelectric conversion element SA covers the wavelength band (13.5 nm) of in-band light and the wavelength band of out-band light. The wavelength-selecting filter F is made of, for example, zirconium, silicon, or the like, and has transmittivity only with respect to in-band light while blocking out-band light. Thus, the light-quantity sensor 12 is able to detect the light quantity of in-band light only. The detectable band of the light-quantity sensor 12 is, for example, as shown with the symbol $E_{12}$ in Fig. 3(b). The curve in Fig. 3(b) is an example of the emission spectrum of the laser plasma light source la. Actually, the emission spectrum is not necessarily as this curve, and fluctuates according to the operating status of the laser plasma light source 1a.

Furthermore, as shown on the right side of Fig. 3(a), the light-quantity sensor 13 includes a photoelectric conversion element SA having the same characteristic as that used in the light-quantity sensor 12. Thus, the light-quantity sensor 13 is able to detect the sum of the light quantity of out-band light and the light quantity of in-band light. The detectable band of the light-quantity sensor 13 is, for example, as shown with the symbol $E_{13}$ in Fig. 3(b).

Next, the mirror adjusting system of the projection exposure apparatus will be described.

Fig. 4 is a flow chart of the operation of the controlling part 9 regarding the mirror adjusting system. In Fig. 4, the operation of the circuit portion and the operation of the computer portion of the controlling part 9 are represented without making any distinction between them.

As shown in Fig. 4, the controlling part 9 refers to the outputs of the light-quantity sensors 12 and 13 (step S1), calculates the light quantity of in-band light and the light quantity of out-band light incident on the projection optical system 6, independently, based on the outputs thereof (step S2), determines adjusting amounts of the projection optical system 6 (here, adjusting amounts in the optical axis directions of the mirrors) based on the calculated light-quantities (step S3), and gives an instruction for adjustment and adjusting amounts (here, adjusting amounts in the optical axis directions of the mirrors) to the mirror adjusting mechanism 8 to adjust projection optical system 6 (step S4). The steps S1 to S4 are executed repeatedly during the exposure period. The steps S2 and S3 will be described in detail below.

(Description of Step S2)

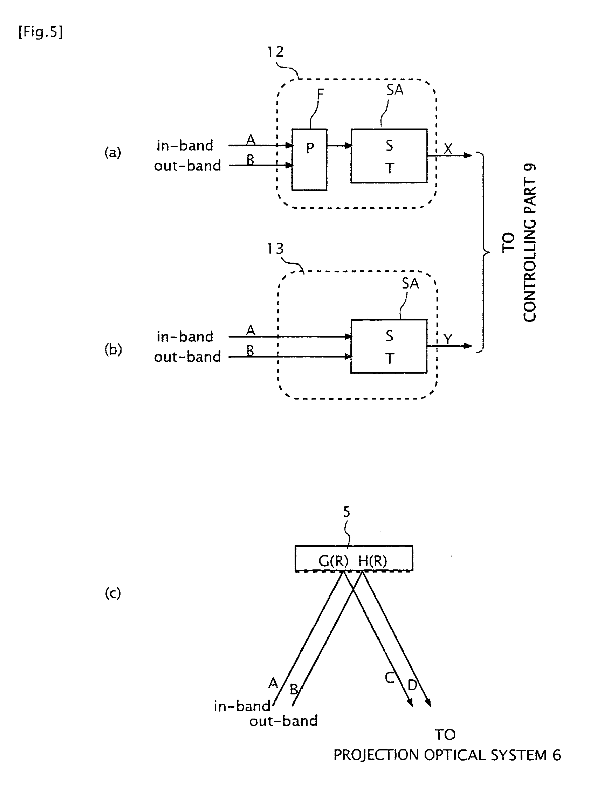

Now, it is assumed that the light quantity of in-band light incidents on the light-quantity sensors 12 and 13 is A and the light quantity of out-band light incidents on the light-quantity sensors 12 and 13 is B, as shown in Figs.5 (a) and (b). Furthermore, the transmittance of the wavelength-selecting filter F in the light-quantity sensor 12 is represented by P, the sensitivity coefficient (conversion efficiency) for in-band light of the photoelectric conversion element SA is represented by S, and the sensitivity coefficient (conversion efficiency) for out-band light of the photoelectric conversion element SA is represented by T.

In the light-quantity sensor 12, as shown in Fig. 5(a), in-band light having a light quantity A is attenuated by the transmittance P of the wavelength-selecting filter F and then enters the photoelectric conversion element SA to be converted to an electrical signal by the conversion efficiency S. On the other hand, out-band light having a light quantity B incident on the light-quantity sensor 12 is blocked by the wavelength-seiecting filter F. Thus, the output X of the light-quantity sensor 12 is given by $X = A \times P \times S$.

Furthermore, in the light-quantity sensor 13, as shown in Fig. 5(b), both of in-band light having a light quantity A and out-band light having a light quantity B enter the photoelectric conversion element SA without being attenuated at all. The in-band light is converted to an electrical signal by the conversion efficiency S, and the out-band light is converted to an electrical signal by the conversion efficiency T. Thus, the output Y of the light-quantity sensor 13 is given by $Y = A \times S + B \times T$.

Hence, the following equation (1) is derived.

[Eq. 1]

$$\begin{bmatrix} X \\ Y \end{bmatrix} = \begin{bmatrix} APS \\ AS + BT \end{bmatrix} = \begin{bmatrix} PS & 0 \\ S & T \end{bmatrix} \cdot \begin{bmatrix} A \\ B \end{bmatrix} \qquad \cdots(1)$$

Thus, the controlling part 9 calculates the light quantity A of the in-band light and the light quantity B of the out-band light independently by applying the output X of the light-quantity sensor 12 and the output Y of the light-quantity sensor 13 to the following equation (2). Information necessary for this calculation, that is, information about the characteristics of the light-quantity sensors 12 and 13 such as "A", "P", "S", and "T' is stored in the controlling part 9 in advance.
**[Eq. 2]**

$$\begin{bmatrix} A \\ B \end{bmatrix} = \begin{bmatrix} PS & 0 \\ S & T \end{bmatrix}^{-1} \cdot \begin{bmatrix} X \\ Y \end{bmatrix} \quad \cdots (2)$$

Note that the calculated light quantities A and B represent the light quantities of in-band light and out-band light which have entered the light-quantity sensors 12 and 13, and are thus equivalent to the light quantities of in-band light and out-band light which will enter the reticle 5.

Next, as shown in Fig. 5(c), when the reflection coefficient for in-band light of the reticle 5 is represented by G[R] and the reflection coefficient for out-band light of the reticle 5 is represented by H[R], the light quantity C of in-band light incident on the projection optical system 6 is given by $C = A \times G[R]$, and the light quantity D of out-band light incident on the projection optical system 6 is given by $D = B \times H[R]$. In other words, the following equation (3) is derived.
**[Eq. 3]**

$$\begin{cases} C = A \times G[R] \\ D = B \times H[R] \end{cases} \quad \cdots (3)$$

The reflection coefficients G[R] and H[R] are coefficients determined for each reticle ([R] represents a function of a reticle).

Thus, the controlling part 9 estimates the light quantity C of in-band light incident on the projection optical system 6 and the light quantity D of out-band light incident on the projection optical system 6 independently by applying the light quantities A and B to the above equation (3).

Note that, Information necessary for this estimation, that is, information about the characteristic of the reticle 5 such as "G[R]" and "H[R]" is stored in the controlling part 9 in advance.

(Description of Step S3)

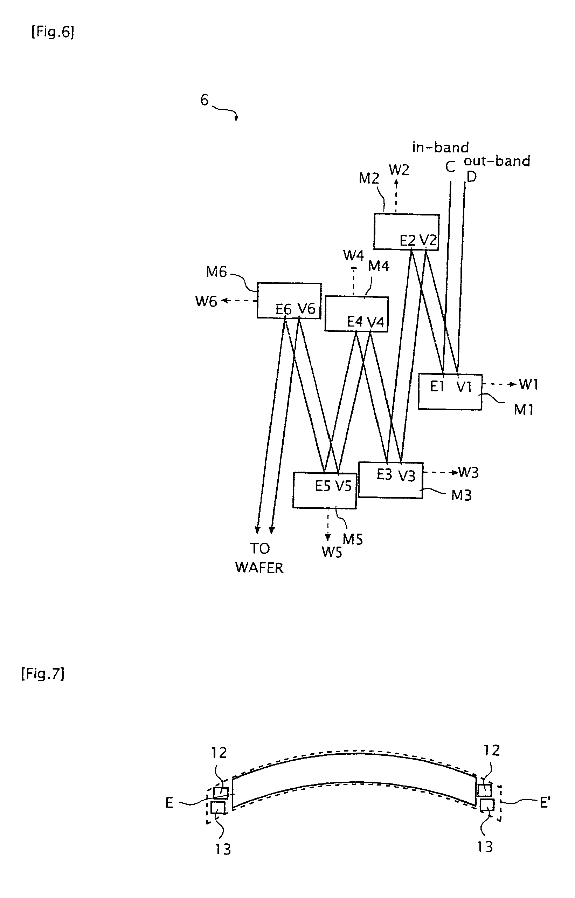

Now, as shown in Fig. 6, the heat-absorption coefficient for in-band light of a mirror Mi in the projection optical system 6 is represented by $E_i$, and the heat-absorption coefficient for out-band light of the mirror $M_i$ in the projection optical system 6 is represented by $V_i$. However, the heat-absorption coefficient $E_i$ is a heat amount (heat-absorption amount) absorbed by the mirror $M_i$ due to in-band light incident on the projection optical system 6 when the light quantity of the in-band light is "one", and the heat-absorption coefficient $V_i$ is a heat amount (heat-absorption amount) absorbed by the mirror $M_i$ due to out-band light incident on the projection optical system 6 when the light quantity of the out-band light is "one". In this specification, "heat-absorption amount of a mirror" means "light quantity of light changed to heat by a mirror", and is represented by light energy per unit time or the like.

When the light quantity of in-band light incident on the projection optical system 6 is C, the heat-absorption amount $w_i$ of the mirror Mi caused by the in-band light is given by $w_i = C \times E_i$.

Furthermore, when the light quantity of out-band light incident on the projection optical system 6 is D, the heat-absorption amount $w_i'$ of the mirror $M_i$ caused by the out-band light is given by $w_i' = D \times V_i$.

The sum of the heat-absorption amount $w_i$ of the mirror $M_i$ caused by the in-band light and the heat-absorption amount $w_i'$ of the mirror $M_i$ caused by the out-band light is a total heat-absorption amount $W_i$ of the mirror $M_i$.

Thus, the controlling part 9 estimates the heat-absorption amounts W1, W2, W3, W4, W5, and W6 of the mirrors M1, M2, M3, M4, M5, and M6 by applying the light quantity C of in-band light and the light quantity D of out-band light incident on the projection optical system 6 to the following equation (4).

[Eq. 4]

$$W_i = \begin{bmatrix} C & D \end{bmatrix} \cdot \begin{bmatrix} E_i \\ V_i \end{bmatrix} \qquad \cdots (4)$$

Note that, information necessary for this estimation, that is, information about the characteristics of the mirrors M 1, M2, M3, M4, M5, and M6 such as "E1", "E2", "E3", "E4", "E5", "E6", "V1", "V2", "V3", "V4", "V5", and "V6" is stored in the controlling part 9 in advance. The heat-absorption coefficient $E_i$ of the mirror $M_i$ depends on the reflectivity for in-band light of the mirror $M_i$ and the mirrors on the upstream side than it, and the heat-absorption coefficient $V_i$ of the mirror $M_i$ depends on the reflectivity for out-band light of the mirror $M_i$ and the mirrors on the upstream side than it.

Further, the controlling part 9 calculates the deformation rate P1 of the mirror M1 at this time point based on the heat-absorption amount W1 of the mirror M1 and the history of the heat-absorption amount (the deformation rate P1 can be calculated based on at least the heat-absorption amount W1 of the mirror M1 and the previous value of the heat-absorption amount. However, the content of the calculation depends on the time constant of the heat balance peculiar to the mirror M1). Note that, a deformation amount which becomes a basis of the deformation rate P1 is obtained when the mirror M1 has reached a steady state while the light quantity C of the in-band light and the light quantity D of the out-band light are being kept to reference values, respectively.

Likewise, the controlling part 9 calculates the deformation rate P2 of the mirror M2 at this time point based on the heat-absorption amount W2 of the mirror M2 and the history of the heat-absorption amount (the deformation rate P2 can be calculated based on at least the heat-absorption amount W2 of the mirror M2 and the previous value of the heat-absorption amount. However, the content of the calculation depends on the time constant of the heat balance peculiar to the mirror M2). Note that, a deformation amount which becomes a basis of the deformation rate P2 is obtained when the mirror M2 has reached a steady state while the light quantity C of the in-band light and the light quantity D of the out-band light are being kept to reference values, respectively.

Likewise, the controlling part 9 calculates the deformation rate P3 of the mirror M3 at this time point based on the heat-absorption amount W3 of the mirror M3 and the history of the heat-absorption amount (the deformation rate P3 can be calculated based on at least the heat-absorption amount W3 of the mirror M3 and the previous value of the heat-absorption amount. However, the content of the calculation depends on the time constant of the heat balance peculiar to the mirror M3). Note that, a deformation amount which becomes a basis of the deformation rate P3 is obtained when the mirror M3 has reached a steady state while the light quantity C of the in-band light and the light quantity D of the out-band light are being kept reference values, respectively.

Likewise, the controlling part 9 calculates the deformation rate P4 of the mirror M4 at this time point based on the heat-absorption amount W4 of the mirror M4 and the history of the heat-absorption amount (the deformation rate P4 can be calculated based on at least the heat-absorption amount W4 of the mirror M4 and the previous value of the heat-absorption amount. However, the content of the calculation depends on the time constant of the heat balance peculiar to the mirror M4). Note that, a deformation amount which becomes a basis of the deformation rate P4 is obtained when the mirror M4 has reached a steady state while the light quantity C of the in-band light and the light quantity D of the out-band light are being kept reference values, respectively.

Likewise, the controlling part 9 calculates the deformation rate P5 of the mirror M5 at this time point based on the heat-absorption amount W5 of the mirror M5 and the history of the heat-absorption amount (the deformation rate P5 can be calculated based on at least the heat-absorption amount W5 of the mirror M5 and the previous value of the heat-absorption amount. However, the content of the calculation depends on the time constant of the heat balance peculiar to the mirror M5). Note that, a deformation amount which becomes a basis of the deformation rate P5 is obtained when the mirror M5 has reached a steady state while the light quantity C of the in-band light and the light quantity D of the out-band light are being kept to reference values, respectively.

Likewise, the controlling part 9 calculates the deformation rate P6 of the mirror M6 at this time point based on the heat-absorption amount W6 of the mirror M6 and the history of the heat-absorption amount (the deformation rate P6 can be calculated based on at least the heat-absorption amount W6 of the mirror M6 and the previous value of the heat-absorption amount. However, the content of the calculation depends on the time constant of the heat balance peculiar to the mirror M6). Note that, a deformation amount which becomes a basis of the deformation rate P6 is obtained when the mirror M6 has reached a steady state while the light quantity C of the in-band light and the light quantity D of the out-band light are being kept reference values, respectively.

As described above, when the deformation rates P1, P2, P3, P4, P5; and P6 of the mirrors M1, M2, M3, M4, M5, and M6 have become known as described above, the amount of fluctuation which has been caused in the image-forming characteristics of the projection optical system 6 at that time point becomes known.

In addition, the controlling part 9 determines adjusting amounts of the projection optical system 6 (adjusting amounts Z1, Z2, Z3, Z4, Z5, and Z6 of the mirrors M1, M2, M3, M4, M5, and M6) necessary for controlling fluctuations in the image-forming characteristics, based on the deformation rates P1, P2, P3, P4, P5, and P6 of the respective mirrors (up to this point, step 53 has been described).

As described above, the present projection exposure apparatus is equipped with a sensor part (light-quantity sensors 12 and 13) to detect the light quantity of in-band light and the light quantity of out-band light independently (see Figs.2 and 3), and the controlling part 9 estimates, based on these two kinds of detected light quantities, the amount of fluctuation in the image-forming characteristics of the projection optical system 6 caused by irradiation heat of light.

Thus, even if the light quantity of in-band light and the light quantity of out-band light have fluctuated individually, the amount of fluctuation in the image-forming characteristics of the projection optical system 6 can be estimated accurately. As a result, the adjusting amount of the projection optical system 6 becomes an appropriate value, and the mirror adjusting system thus operates correctly.

Furthermore, the controlling part 9 estimates, based on these two kinds of detected light quantities, the heat-absorption amount of the projection optical system 6 caused by in-band light and the heat-absorption amount of the projection optical system 6 caused by out-band light independently, and regards the sum of the heat-absorption amounts as the total heat-absorption amount of the projection optical system 6 (see Eqs. (1) to (4)). Thus, the fluctuation amount described above is estimated with high accuracy.

Furthermore, the sensor part of the projection exposure apparatus includes the photoelectric conversion elements SA and the wavelength-selecting filter F which are typical optical elements (see Fig. 3(a)), thus being very simple.

(Others)

Note that, in the present projection exposure apparatus, when a reticle blind is arranged before the reticle 5 shown in Fig. 1, the light-quantity sensors 12 and 13 may be provided on the light entering side surface of the reticle blind.

Furthermore, the place to arrange the light-quantity sensors 12 and 13 may be in any other place such as an optical path between the projection optical system 6 and the reticle 5 or an optical path in the projection optical system 6. However, it is desirable that the place to arrange them may be on the upstream than an aperture member (not shown) in the projection optical system 6, and in an optical path of a beam which does not pass through the aperture member. For example, the place to arrange the light-quantity sensors 12 and 13 may be on the light entering side surface of the aperture member in the projection optical system 6.

Furthermore, the present projection exposure apparatus may be equipped with an exposure-amount controlling system using the output of the light-quantity sensor 12 (= output indicating the light quantity of in-band light). The exposure controlling system performs feed-back control of the power of the laser plasma light source 1a in such a manner that the output value of the light-quantity sensor 12 and/or the time integration value of the output of light-quantity sensor 12 are kept to predetermined values.

Furthermore, as the light source of the present projection exposure apparatus, any other EUV light source such as a discharge plasma light source or a synchrotron light source may be used instead of the laser plasma light source 1a.

Furthermore, the mirror adjusting mechanism 8 of the projection exposure apparatus may be one adjusting the positions of the mirrors M1, M2, M3, M4, M5, and M6, or one adjusting the pressures of the mediums among the mirrors M1, M2, M3, M4, M5, and M6, provided that they are able to adjust the image-forming characteristics of the projection optical system 6.

Furthermore, although one set of the light-quantity sensors 12 and 13 is arranged in the projection exposure apparatus, two or more (two in Fig. 7) sets of the light-quantity sensors 12 and 13, for example, may be arranged around the same luminous flux as shown in Fig. 7. When the output of two or more light-quantity sensors arranged around the same luminous flux is used, the light quantity of the luminous flux can be detected with higher accuracy.

Furthermore, in the present projection exposure apparatus, the influence of light which is reflected by the wafer 7 and then returns to the projection optical system 6 is neglected. However, in an EUVL, the light quantity of light reflected by the wafer 7 is extremely small (details will be described later), so that the light quantity can be adjusted with sufficient accuracy even if the influence is neglected.

[Second Embodiment]

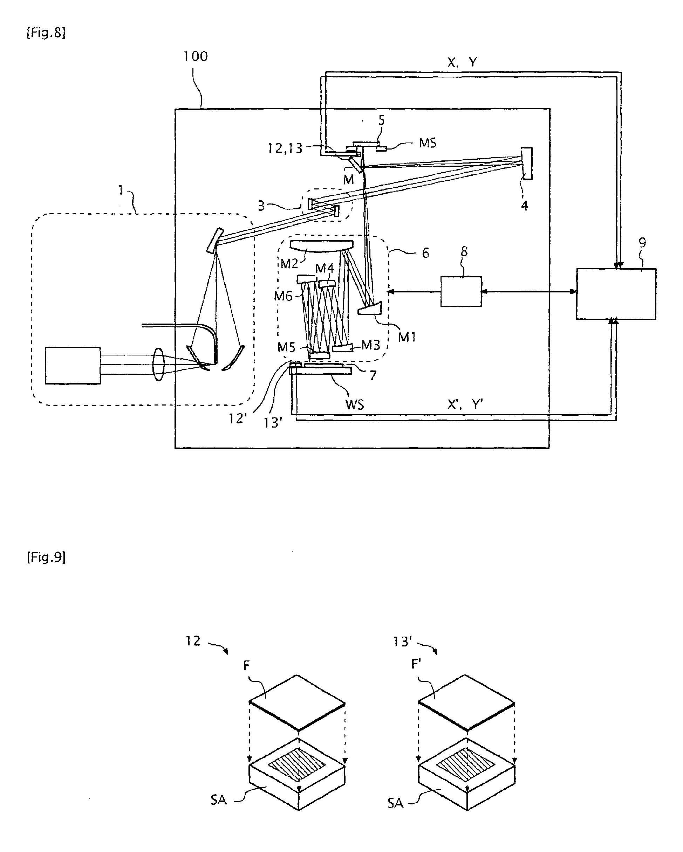

The second embodiment of the present invention will be described below with reference to Fig. 8. Here, only points different from the first embodiment will be described.

Fig. 8 is a schematic configuration diagram of the present projection exposure apparatus. The configuration of the second embodiment is different from that of the first embodiment mainly in that a light-quantity sensor 12' equivalent to the light-quantity sensor 12 and a light-quantity sensor 13' equivalent to the light-quantity sensor 13 are provided on the wafer stage WS. Hereinafter, the light-quantity sensors 12' and 13' are referred to as "wafer side sensors 12' and 13", and the light-quantity sensors 12 and 13 provided near the reticle 5 are referred to as "reticle side sensors 12 and 13".

The controlling part 9 of this embodiment repeats adjustment similar to that of the first embodiment using the reticle side sensors 12 and 13 during an exposure period. In addition, the controlling part 9 of this embodiment corrects the heat-absorption coefficients (E1, V1, E2, V2, E3, V3, E4, V4, E5, V5, E6 and V6) of the projection optical system 6 using the wafer side sensors 12' and 13' for each appropriate time outside the exposure period.

This correction is performed to address temporal changes in the reflection/absorption characteristics of the projection optical system 6, because there is a possibility that the reflectivities R1, R2, R3, R4, R5, and R6 of the mirrors M1, M2, M3, M4, M5, and M6 in the projection optical system 6 decrease with time due to contaminant generated in the projection exposure apparatus. In addition, contaminant is easier to adhere to mirrors on the upstream side, so that the temporal changes are remarkable.

The operation of the controlling part 9 regarding this correction will be described in detail below.

When performing this correction, the controlling part 9 drives the wafer stage WS to arrange the wafer side sensors 12' and 13' instead of the wafer 7 on the optical path. At that time, light (in-band light and out-band light) from the projection optical system 6 enters the wafer side sensors 12' and 13'.

The controlling part 9, at that time, refers to the output X' of the wafer side sensor 12' and the output Y of the wafer side sensor 13', and calculates the light quantity C' of in-band light emitted from the projection optical system 6 and the light quantity D' of out-band light emitted from the projection optical system 6, respectively. The calculation method is equivalent to that used when light quantities A and B are calculated in the first embodiment.

At about the same time when the controlling part 9 refers to the outputs X' and Y', it refers to the output X of the reticle side sensor 12 and the output Y of the reticle side sensor 13, and calculates the light quantity C of in-band light incident on the projection optical system 6 and the light quantity D of out-band light incident on the projection optical system 6, respectively. The calculation method is as described in the first embodiment.

In addition, the controlling part 9 determines whether or not there has been a fluctuation in the reflection/absorption characteristics for in-band light of the projection optical system 6 based on the light quantity C' of in-band light emitted from the projection optical system 6 and the light quantity C of in-band light incident on the projection optical system 6 (while comparing them with the previous values), and corrects the values of heat-absorption coefficients (E1, E2, E3, E4, E5, and E6) regarding in-band light when there has been a fluctuation. The correction amounts ($\Delta$E1, $\Delta$E2, $\Delta$E3, $\Delta$E4, $\Delta$E5, and $\Delta$E6) of the heat-absorption coefficients (E1, E2, E3, E4, E5, and E6) may be determined based on the light quantities C and C' only. However, it is more desirable in high accurate correction that they be determined based on not only the light quantities C and C' but also data obtained by advance measurement (that is, data of the temporal change curves of the reflection/absorption characteristics for in-band light of the mirrors M1, M2, M3, M4, M5, and M6). Information necessary for the determination and correction is stored in the controlling part 9 in advance.

Furthermore, the controlling part 9 determines whether or not there has been a fluctuation in the reflection /absorption characteristics for out-band light of the projection optical system 6 based on the light quantity D' of out-band light emitted from the projection optical system 6 and the light quantity D of out-band light incident on the projection optical system 6 (while comparing them with the previous values), and corrects the values of heat-absorption coefficients (V1, V2, V3, V4, V5, and V6) regarding out-band light when there has been a fluctuation. The correction amounts ($\Delta$V1, $\Delta$V2, $\Delta$V3, $\Delta$V4, $\Delta$V5, and $\Delta$V6) of the heat-absorption coefficients (V1, V2, V3, V4, V5, and V6) may be determined based on the light quantities D and D' only. However, it is more desirable in high accurate correction that they be determined based on not only the light quantities D and D' but also data obtained by advance measurement (that is, data of the temporal change curves of the reflection/absorption characteristics for out-band light of the mirrors M1, M2, M3, M4, M5, and M6). Information necessary for the determination and correction is stored in the controlling part 9 in advance.

According to the above corrections, even if any temporal change has been caused in the reflection/absorption characteristics of the projection optical system 6, the heat-absorption coefficients (E1, V1, E2, V2, E3, V3, E4, V4, E5, V5, E6, and V6) are renewed to correct values. As a result, the mirror adjusting system of the projection exposure apparatus continues to operate correctly even if any temporal change has been caused in the reflection/absorption characteristics of the projection optical system 6.

In addition, the controlling part 9 of this embodiment corrects the heat-absorption coefficients (E1, E2, E3, E4, E5, and E6) regarding in-band light and the heat-absorption coefficients (V1, V2, V3, V4, V5, and V6) regarding out-band light, independently, based on four kinds of light quantities (C, C', D, and D') detected, so that its correction accuracy is high.

[Others]

Note that, in each of the sensor parts of the projection exposure apparatuses described above, a light-quantity sensor 12 detecting the light quantity of in-band light only, and a light-quantity sensor 13 detecting the sum of the light quantity of in-band light and the light quantity of out-band light are provided. However, in addition to the above sensor parts, a senor part as shown in any one of Figs.9, 10, and 11 can also be applied as a sensor part for detecting the light quantity of in-band light and the light quantity of out-band light independently.

The sensor part shown in Fig. 9 includes: a light-quantity sensor 12 in which a wavelength-selecting filter F that has transmittivity only with respect to in-band light is mounted on a photoelectric conversion element SA; and a light-quantity sensor 13' in which a wavelength-selecting filter F' that has transmittiviy only with respect to out-band light is mounted on a photoelectric conversion element SA. The material of the wavelength-selecting filter F' is, for example, glass.

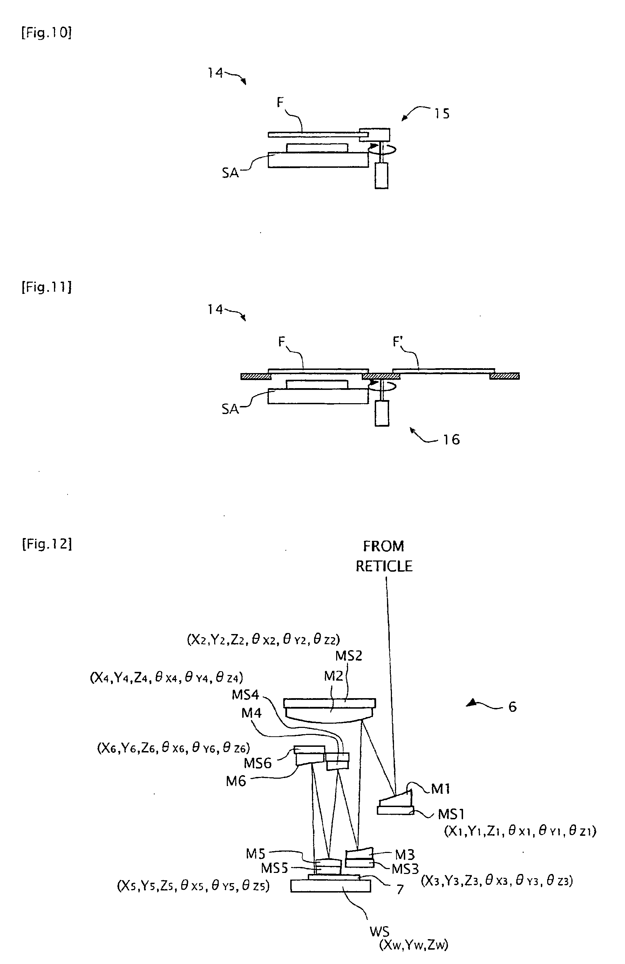

The sensor part shown in Fig. 10 includes: a wavelength-selecting filter F that has transmittiviy only with respect to in-band light or out-band light; a photoelectric conversion element SA; and a mechanism 15 which places the wavelength-selecting filter F over the front surface of the photoelectric conversion element SA and displaces it wherefrom.

The sensor part shown in Fig. 11 includes: a wavelength-selecting filter F that has transmittiviy only with respect to in-band light; a wavelength-selecting filter F' that has transmittiviy only with respect to out-band light; a photoelectric conversion element SA; and a mechanism 16 which alternately places the wavelength-selecting filters F and F' over the front surface of the photoelectric conversion element SA.

Note that, when the sensor part shown in Fig. 10 or 11 is used, the controlling part 9 drives the mechanism 15 or 16, and refers to both of the output X of the sensor part obtained before driving and the output Y of the sensor part obtained after driving.

[Third Embodiment]

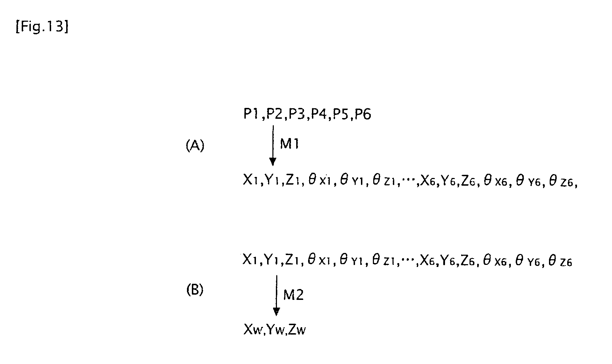

The third embodiment of the present invention will be described below with reference to Figs. 12 and 13. This embodiment is a variation of the first embodiment. Here, only points different from the first embodiment will be described.

The points different from the first embodiment are that subjects of adjustment for controlling fluctuations in the image-forming performance in the third embodiment are the following ones.

* Positions of the mirrors M1, M2, M3, M4, M5, and M6 in directions (X-axis directions) perpendicular to the respective optical axis directions
*Positions of the mirrors M1, M2, M3, M4, M5, and M6 in directions (Y-axis directions) perpendicular to the respective optical axis directions and X-axis directions
* Positions of the mirrors M1, M2, M3, M4, M5, and M6 in the respective optical axis directions (Z-axis directions)

* Arrangement angles around the respective X-axes (in the $\theta x$-axis directions) of the mirrors M1, M2, M3, M4, M5, and M6
* Arrangement angles around the respective Y-axes (in the $\theta_Y$-axis directions) of the mirrors M1. M2, M3, M4, M5, and M6
* Arrangement angles around the respective Z-axes (in the $\theta_z$-axis directions) of the mirrors M1, M2, M3, M4, M5, and M6

*A position in the X-axis direction of the wafer 7
*A position in the Y-axis direction of the wafer 7
*A position in the Z-axis direction of the wafer 7

For this reason, in this embodiment, as shown in Fig. 12, each of the mirrors M1, M2, M3, M4, M5, and M6 is supported by mirror stages MS1, MS2, MS3, MS4, MS5, and MS6 having 6 degrees of freedom, respectively. Six degrees of freedom are a degree of freedom of a position in an X-axis direction, a degree of freedom of a position in a Y-axis direction, a degree of freedom of a position in a Z-axis direction, a degree of freedom of an arrangement angle in a $\theta_x$-axis direction, a degree of freedom of an arrangement angle in a $\theta_Y$-axis direction, and a degree of freedom of an arrangement angle in a $\theta_z$-axis direction.

These mirror stages MS1, MS2, MS3, MS4, MS5, and MS6 correspond to the mirror adjusting mechanism 8 (see Fig. 1) of this embodiment. For each of the mirror stages MS1, MS2, MS3, MS4, MS5, and MS6, a parallel link type stage, for example, can be applied.

On the other hand, the wafer stage WS supporting the wafer 7 may have at least three degrees of freedom like those in a typical projection exposure apparatus. Three degrees of freedom are a degree of freedom of a position in an X-axis direction, a degree of freedom of a position in a Y-axis direction, and a degree of freedom of a position in a Z-axis direction.

In the following description, the adjustment amount of the mirror $M_i$ in the X-axis direction given by the mirror stage MSi is represented by $X_i$, the adjustment amount of the mirror Mi in the Y-axis direction given by the mirror stage MSi is represented by $Y_i$, the adjustment amount of the mirror Mi in the Z-axis direction given by the mirror stage MSi is represented by $Z_i$, the adjustment amount of the mirror $M_i$ in the $\theta_x$-axis direction given by the mirror stage MSi is represented by $\theta_{Xi}$, the adjustment amount of the mirror $M_i$ in the $\theta y$-axis direction given by the mirror stage MSi is represented by $\theta_{Yi}$, the adjustment amount of the mirror $M_i$ in the $\theta_z$-axis direction given by the mirror stage MSi is represented by $\theta_{Zi}$, the adjustment amount of the wafer 7 in the X-axis direction given by the wafer stage WS is represented by $X_w$, the adjustment amount of the wafer 7 in the Y-axis direction given by the wafer stage WS is represented by $Y_w$, the adjustment amount of the wafer 7 in the Z-axis direction given by the wafer stage WS is represented by $Z_w$.

Thus, it is considered that when adjustment amounts $X_1$, $Y_1$, $Z_1$, $\theta_{X1}$, $\theta_{Y1}$, $\theta_{Z1}$, $X_2$, $Y_2$, $Z_2$, $\theta_{X2}$, $\theta_{Y2}$, $\theta_{22}$ ... $X_6$, $Y_6$, $Z_6$, $\theta_{X6}$, $\theta_{Y6}$, $\theta_{Z6}$, in six axis directions of the mirrors are used, fluctuations in the image-forming characteristics of the projection optical system 6 can be surely controlled even if they are complicated. As described above, since the projection optical system 6 is a reflection type and an off-axis optical system, deformation produced in the mirror $M_i$ is not always rotationally symmetric, and fluctuations caused in the image-forming characteristics can be non-rotationally symmetric, so that such control becomes extremely effective.

However, if fluctuations in the image-forming characteristics are controlled using only the adjusting amounts $X_i$, $Y_i$, $Z_i$, $\theta X_i$, $\theta Y_i$, and $\theta_{Zi}$ of the mirrors, there is a possibility that computation for determining the adjusting amounts becomes complicated.

For this reason, in this embodiment, the adjusting amounts $X_i$, $Y_i$, $Z_i$, $\theta_{Xi}$, $\theta_{Yi}$, and $\theta_{Zi}$ of the mirrors are combined with the adjusting amounts $X_w$, $Y_w$, and $Z_w$ of the wafer 7.

Incidentally, the above respective adjusting amounts are determined by the controlling part 9 like the first embodiment. The determination is made at step S3 in Fig. 4 like the first embodiment.

Fig. 13 illustrates a determining method of this embodiment.

First, the adjusting amounts $X_1$, $V_1$, $Z_1$, $\theta_{X1}$, $\theta_{Y1}$, $\theta_{Z1}$, $X_2$, $Y_2$, $Z_2$, $\theta_{X2}$, $\theta_{Y2}$, $\theta_{22}$, ..., $X_6$, $Y_6$, $Z_6$, $\theta X_6$, $\theta_{Y6}$, and $\theta_{Z6}$ of the mirrors are determined as shown in Fig. 13(A), and then the adjusting amounts $X_w$, $Y_w$, and $Z_w$ of the wafer are determined as shown in Fig. 13(B).

The adjusting amounts $X_1$, $Y_1$, $Z_1$, $\theta X_1$, $\theta_{Y1}$, $\theta_{Z1}$, $X_2$, $Y_2$, $Z_2$, $\theta_{X2}$, $\theta_{Y2}$, $\theta_{22}$, ..., $X_6$, $Y_6$, $Z_6$, $\theta_{X6}$, $\theta_{Y6}$, and $\theta_{Z6}$ of the mirrors are determined based on the deformation rates P1, P2, P3, P3, P5, and P6 of the mirrors as in the case that the adjusting amounts $Z_1$, $Z_2$, $Z_3$, $Z_4$, $Z_5$, and $Z_6$ are determined in the first embodiment. Here, the deformation rates P1, P2, P3, P4, P5, and P6 of the mirrors are merged into a deformation rate vector P as the following equation (5).

[Eq. 5]

$$P = \begin{bmatrix} P1 \\ P2 \\ P3 \\ P4 \\ P5 \\ P6 \end{bmatrix} \quad \cdots (5)$$

Furthermore, the adjusting amounts $X_1$, $Y_1$, $Z_1$, $\theta_{X1}$, $\theta_{Y1}$, $\theta_{Z1}$, $X_2$, $Y_2$, $Z_2$, $\theta_{X2}$, $\theta_{Y2}$, $\theta_{Z2}$, ..., $X_6$, $Y_6$, $Z_6$, $\theta_{X6}$, $\theta_{Y6}$, and $\theta_{Z6}$ of the mirrors are merged into an adjusting amount vector D as the following equation (6).

[Eq. 6]

$$D = \begin{bmatrix} X_1 \\ Y_1 \\ Z_1 \\ \theta_{X1} \\ \theta_{Y1} \\ \theta_{Z1} \\ \vdots \\ X_6 \\ Y_6 \\ Z_6 \\ \theta_{X6} \\ \theta_{Y6} \\ \theta_{Z6} \end{bmatrix} \quad \cdots (6)$$

Then, the adjusting amounts $X_1$, $Y_1$, $Z_1$, $\theta_{X1}$, $\theta_{Y1}$, $\theta_{Z1}$, $X_2$, $Y_2$, $Z_2$, $\theta_{X2}$, $\theta_{Y2}$, $\theta_{Z2}$, ..., $X_6$, $Y_6$, $Z_6$, $\theta_{X6}$, $\theta_{Y6}$, and $\theta_{Z6}$ of the mirrors are uniquely determined by the following equation (7).
[Eq. 7]

$$D = M_1 P \quad \cdots (7)$$

where $M_1$ in the equation (7) represents a matrix with 36 rows and six columns. The matrix $M_1$ is as shown in the equation (8).
[Eq. 8]

$$M_1 = \begin{bmatrix} m_{11} & m_{12} & m_{13} & m_{14} & m_{15} & m_{16} \\ m_{21} & m_{22} & m_{23} & m_{24} & m_{25} & m_{26} \\ m_{31} & m_{32} & m_{33} & m_{34} & m_{35} & m_{36} \\ m_{41} & m_{42} & m_{43} & m_{44} & m_{45} & m_{46} \\ \vdots & \vdots & \vdots & \vdots & \vdots & \vdots \\ m_{361} & m_{362} & m_{363} & m_{364} & m_{365} & m_{366} \end{bmatrix} \quad \cdots (8)$$

The value of each element $m_{k1}$ of the matrix $M_1$ is calculated by an optical calculation based on the design data of the projection optical system 6, and is stored in the controlling part 9 in advance. The matrix $M_1$ is a conversion matrix which converts the deformation rate vector P into the adjusting amount vector D necessary for controlling fluctuations in the image-forming characteristics.

For example, the first column vector $[m_{11}, m_{21}, ..., m_{361}]$ constituting the matrix $M_1$ corresponds to an adjustment amount vector D necessary for controlling fluctuations in the image-forming characteristics caused when the deformation rate P1 of the mirror M1 is one, little by little, with 36 kinds of adjustment amounts of the six mirrors.

Furthermore, the second column vector $[m_{12}, m_{22}, ..., m_{362}]$ constituting the matrix $M_1$ corresponds to an adjustment amount vector D necessary for controlling fluctuations in the image-forming characteristics caused when the deformation rate P2 of the mirror M2 is one, little by little, with 36 kinds of adjustment amounts of the six mirrors.

Furthermore, the third column vector $[m_{13}, m_{23}, ..., m_{363}]$ constituting the matrix $M_1$ corresponds to an adjustment amount vector D necessary for controlling fluctuations in the image-forming characteristics caused when the deformation rate P3 of the mirror M3 is one, little by little, with 36 kinds of adjustment amounts of the six mirrors.

Furthermore, the fourth column vector $[m_{14}, m_{24}, ..., m_{364}]$ constituting the matrix $M_1$ corresponds to an adjustment amount vector D necessary for controlling fluctuations in the image-forming characteristics caused when the deformation rate P4 of the mirror M4 is one, little by little, with 36 kinds of adjustment amounts of the six mirrors.

Furthermore, the fifth column vector $[m_{15}, m_{25}, ..., m_{365}]$ constituting the matrix $M_1$ corresponds to an adjustment amount vector D necessary for controlling fluctuations in the image-forming characteristics caused when the deformation rate P5 of the mirror M5 is one, little by little, with 36 kinds of adjustment amounts of the six mirrors.

Furthermore, the sixth column vector $[m_{16}, m_{26}, ...., m_{366}]$ constituting the matrix $M_1$ corresponds to an adjustment amount vector D necessary for controlling fluctuations in the image-forming characteristics caused when the deformation rate P6 of the mirror M6 is one, little by little, with 36 kinds of adjustment amounts of the six mirrors.

However, the value of each element $m_{k1}$ of the matrix $M_1$ has been set in such a manner that the image-shift components of fluctuations in the image-forming characteristics are excluded from the subjects of control. The image-shift components are an image-shift component in the X-axis direction, an image-shift component in the Y-axis direction, and an image-shift component in the Z-axis direction. In other words, the subjects of control of the matrix $M_1$ are limited to the main components except the image-shift components of fluctuations in the image-forming characteristics.

Furthermore, the value of each element $m_{k1}$ of the matrix $M_1$ has been set in advance in such a manner that the adjusting amounts of the mirrors fall within the allowable range (a predetermined stroke).

When determining the adjusting amounts $X_1, Y_1, Z_1, \theta_{X1}, \theta_{Y1}, \theta_{Z1}, X_2, Y_2, Z_2, \theta_{X2}, \theta_{Y2}, \theta_{Z2}, ..., X_6, Y_6, Z_6, \theta_{X6}, \theta_{Y6}$, and $\theta_{Z6}$ of the mirrors using the above matrix $M_1$, the controlling part 9 determines the adjusting amounts $X_w, Y_w$, and $Z_w$ of the wafer based on the determined adjusting amounts $X_1, Y_1, Z_1, \theta X_1, \theta Y_i, \theta_{Z1}), X_2, Y_2, Z_2, \theta_{X2}, \theta_{Y2}, \theta_{Z2}, ..., X_6, Y_6, Z_6, \theta_{X6}, \theta_{Y6}$, and $\theta_{Z6}$.

When the adjusting amounts $X_w, Y_w$, and $Z_w$ of the wafer are merged into an adjusting amount vector Dw, the adjusting amounts $X_w, Y_w$, and Zw are uniquely determined by the following equation (9).

[Eq. 9]

$$D_W = M_2 D \qquad \cdots(9)$$

where $M_2$ in the equation (9) represents a matrix with three rows and 36 columns.

The value of each element of the matrix $M_2$ is also calculated by an optical calculation based on the design data of the projection optical system 6, and is stored in the controlling part 9 in advance. The matrix $M_2$ is a conversion matrix which converts the adjustment amount vector D into the adjusting amount vector $D_w$ necessary for controlling the image-shift components of fluctuations in the image-forming characteristics.

As above, when the values of the adjusting amounts $X_1, Y_1, Z_1, \theta_{X1}, \theta_{Y1}, \theta_{Z1}, X_2, Y_2, Z_2, \theta_{X2}, \theta_{Y2}, \theta_{Z2}, ..., X_6, Y_6, Z_6, \theta_{X6}, \theta_{Y6}$, and $\theta_{Z6}$ of the mirrors and the values of the adjusting amounts $X_w, Y_w$, and Zwof the wafer have been determined, the controlling part 9 performs actual adjustment with the same timing as step S4 in Fig. 4.

In this adjustment, the determined values of the adjusting amounts $X_1, Y_1, Z_1, \theta_{X1}, \theta_{Y1}$, and $\theta_{Z1}$ and an adjustment instruction are given to the mirror stage MS1. Furthermore, the determined values of the adjusting amounts $X_2, Y_2, Z_2, \theta_{X2}, \theta_{Y2}$, and $\theta_{Z2}$ and an adjustment instruction are given to the mirror stage MS2. Furthermore, the determined values of the adjusting amounts $X_3, Y_3, Z_3, \theta_{X3}, \theta_{Y3}$, and $\theta_{Z3}$ and an adjustment instruction are given to the mirror stage MS3. Furthermore, the determined values of the adjusting amounts $X_4, Y_4, Z_4, \theta_{X4}, \theta_{Y4}$, and $\theta_{Z4}$ and an adjustment instruction are given to the mirror stage MS4. Furthermore, the determined values of the adjusting amounts $X_5, Y_5, Z_5, \theta_{X5}, \theta_{Y5}$, and $\theta_{Z5}$ and an adjustment instruction are given to the mirror stage MS5. Furthermore, the determined values of the adjusting amounts $X_6, Y_6, Z_6, \theta_{X6}, \theta_{Y6}$, and $\theta_{Z6}$ and an adjustment instruction are given to the mirror stage MS6. Furthermore, the determined values of the adjusting amounts $X_w, Y_w$, and $Z_w$ and an adjustment instruction are given to the wafer stage WS.

As a result, the mirror stages MS1, MS2, MS3. MS4, MS5, and MS6 function in the direction of controlling the main components of fluctuations in the image-forming characteristics of the projection optical system 6, and the wafer stage WS functions in the direction of controlling the image-shift components of the fluctuations.

Thus, according to this embodiment, even if complicated fluctuations have been caused in the image-forming characteristics of the projection optical system 6, they can be surely controlled. Furthermore, in this embodiment, although there are many kinds (39 kinds) of adjusting amounts, predetermined matrixes (M1, M2) are used in calculations for determining the adjusting amounts, so that the determination is performed fast. For example, the one-loop processing (one adjustment) shown in Fig. 4 can be performed with the frequency of one time per one shot during operation of the projection exposure apparatus, or with the frequency of one time in two or three seconds, to follow fluctuations in the image-forming characteristics.

Note that, the contents of the matrixes M1 and M2 necessary for the equations (7) and (8) vary depending on exposure conditions (illumination condition, a set-NA of the projection optical system 6, and the like) of the projection exposure apparatus and/or a kind of reticle 5. For this reason, it is desirable that the controlling part 9 store two or more kinds of matrixes in advance, and use them properly according to combinations of exposure conditions which have been set and a kind of the reticle 5.

Furthermore, in this embodiment, although adjustment by the mirror stage MSi and adjustment by the wafer stage WS are performed with the same timing and the same frequency, the timings and frequencies of both of them may not correspond. For example, the frequency of adjustment by the mirror stage MSi may be set to a high frequency (be continuous), and the frequency of adjustment by the wafer stage WS may be set to the frequency of one time per one shot.

Furthermore, in this embodiment, six degrees of freedom are added to each of the mirror stages MS1, MS2, MS3, MS4, MS5, and MS6. However, when the required accuracy for fluctuation control of the image-forming characteristic is low, the number of degrees of freedom of part of the mirror stages or all of the mirror stages may be reduced to any one of five degrees of freedom, four degrees of freedom, three degrees of freedom, and two degrees of freedom. For example, when the number of degrees of freedom is reduced to five degrees of freedom, it is recommended that the degree of freedom in the $\theta_z$-axis direction is eliminated. Furthermore, for example, when the number of degrees of freedom is reduced to three degrees of freedom, it is recommended that the degree of freedom in the $\theta_z$-axis direction, the degree of freedom in the $\theta_x$-axis direction, and the degree of freedom in the $\theta_y$-axis direction are eliminated.

Furthermore, in this embodiment, the wafer stage WS is used to control fluctuations in the image-forming characteristics. However, the reticle stage MS may be used instead of the wafer stage WS. Furthermore, both of the wafer stage WS and the reticle stage MS may be used, because when the reticle 5 and the wafer 7 are relatively moved, an effect similar to that obtained when only the wafer 7 is moved can be obtained.

Furthermore, in this embodiment, the six mirror stages MS1, MS2, MS3, MS4, MS5. and MS6 are assigned to control the main components of fluctuations in the image-forming characteristics, and the wafer stage WS (and/or the reticle stage MS) is assigned to control the image-shift components of the fluctuations. However, assignment for each component is not limited to this. Part of the main components may be assigned to the wafer stage WS (and/or the reticle stage MS). In that case, it is desirable that degrees of freedom of attitudes (the degree of freedom of arrangement angle in the $\theta_x$-axis direction, the degree of freedom of arrangement angle in the $\theta_y$-axis direction, the degree of freedom of arrangement angle in the $\theta_z$-axis direction, and the like) be added to the stage.

Furthermore, this embodiment is a variation of the first embodiment, and the second embodiment may also be similarly varied.

[Fourth Embodiment]

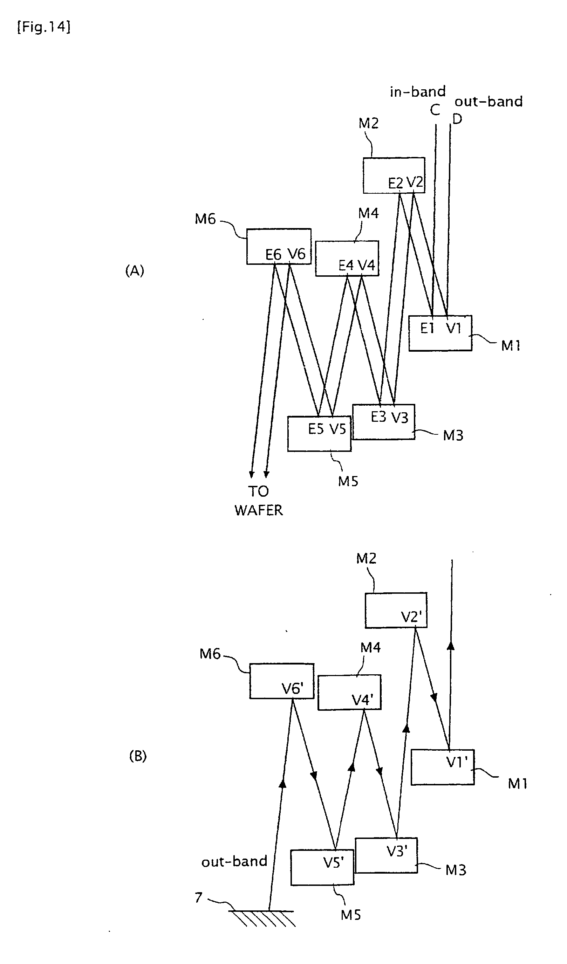

The fourth embodiment of the present invention will be described befow with reference to Figs. 14(A) and 14(B). This embodiment is a variation of the first embodiment. Here, only points different from the first embodiment are described.

The fourth embodiment is different from the first embodiment in a method of calculating a heat-absorption amount at step S3 in Fig. 4.

In the first embodiment, the influence of light (returning light) which is reflected by the wafer 7 and then returns to the projection optical system 6 is neglected. However, practically, the wafer 7 for EUVL does not reflect in-band light, and reflects out-band light, so that there is a possibility that the wafer 7 causes returning light (retuning light constituted by out-band light). In the calculation method of this embodiment, this is considered.

Figs. 14(A) and 14(B) illustrate the calculation method of this embodiment. Fig. 14(A) shows in-band light and out-band light which enter the projection optical system 6 from the reticle side, and Fig. 14(B) shows out-band light which returns to the projection optical system 6 from the wafer side.

Here, the heat-absorption coefficient for in-band light of the mirror $M_i$ is represented by $E_i$. The heat-absorption

coefficient $E_i$ is equivalent to that described in the first embodiment.

Furthermore, heat-absorption coefficients for out-band light of the mirror $M_i$ are represented by $V_i$ and $V_i'$. The heat-absorption coefficient $V_i$ is related to out-band light going to the wafer (Fig. 14(A)), and the heat-absorption coefficient $V_i'$ is related to out-band light returning from the wafer (Fig. 14(B)).

Specifically, the heat-absorption coefficient $V_i$ (Fig. 14(A)) is heat amount (heat-absorption amount) which is absorbed by the mirror $M_i$ due to the out-band light going to the wafer when the quantity of out-band light incident on the projection optical system 6 is "one".

On the other hand, the heat-absorption coefficient $V_i'$ (Fig. 14(B)) is heat amount (heat-absorption amount) which is absorbed by the mirror $M_i$ due to the out-band light returning from the wafer when the quantity of out-band light incident on the projection optical system 6 is "one".

Thus, the controlling part 9 of this embodiment estimates the heat-absorption amount $W_i$ of the mirror $M_i$ by applying the light quantity C of in-band light incident on the projection optical system 6 and the light quantity D of out-band light incident on the projection optical system 6 to the following equation (10).

[Eq. 10]

$$W_i = \begin{bmatrix} C & D \end{bmatrix} \cdot \begin{bmatrix} E_i \\ V_i + V_i' \end{bmatrix} \qquad \cdots (10)$$

Note that, information necessary for this estimation, that is, information of "E1", "E2", "E3", "E4", "E5", "E6", "V1 +V1'", "V2+V2'", "V3+V3'", "V4+V4'", "V5+V5'", and "V6+V6'" is stored in the controlling part 9 in advance.

In this information, the value of the heat-absorption coefficient $E_i$ depends on the reflectivities of the mirror $M_i$ and the mirrors on the upstream side than it for in-band light as described in the first embodiment, and the value of the heat-absorption coefficient $V_i$ depends on the reflectivities of the mirror $M_i$ and the mirrors on the upstream side than it for out-band light as described in the first embodiment.

On the other hand, the value of the heat-absorption coefficient $V_i'$ depends on both of the reflectivity of the mirror $M_i$ and the other mirrors for out-band light and the reflectivity of the wafer 7 for out-band light. More specific description will be given below.

In this description, for simplicity, the reflectivities of the mirror M1, M2, M3, M4, M 5, and M6 for in-band light are uniformly represented by $a_{in}$, and the reflectivities of the mirrors M1, M2, M3, M4, M5, and M6 for out-band light are uniformly represented by $a_{out}$. In addition, the reflectivity for out-band light of the wafer 7 is represented by b.

Hence, the heat-absorption coefficients E1, E2, E3, E4, E5, and E6 are represented as follows (likewise in the first embodiment).

$$E1 = 1 - a_{in}$$

$$E2 = a_{in} \times (1 - a_{in})$$

$$E3 = a_{in}^2 \times (1 - a_{in})$$

$$E4 = a_{in}^3 \times (1 - a_{in})$$

$$E5 = a_{in}^4 \times (1 - a_{in})$$

$$E6 = a_{in}^5 \times (1 - a_{in})$$

Furthermore, the heat-absorption coefficients V1, V2, V3, V4, V5, and V6 are represented as follows (likewise in the first embodiment).
$$V1 = 1 - a_{out}$$

$$V2 = a_{out} \times (1 - a_{out})$$

$$V3 = a_{out}^2 \times (1 - a_{out})$$

$$V4 = a_{out}^3 \times (1 - a_{out})$$

$$V5 = a_{out}^4 \times (1 - a_{out})$$

$$V6 = a_{out}^5 \times (1 - a_{out})$$

Furthermore, the heat-absorption coefficients V6', V5', V4', V3', V2', and V1' are represented as follows using the reflectivity b of the wafer.
$$V6' = a_{out}^6 \times b \times (1 - a_{out})$$

$$V5' = a_{out}^7 \times b \times (1 - a_{out})$$

$$V4' = a_{out}^8 \times b \times (1 - a_{out})$$

$$V3' = a_{out}^9 \times b \times (1 - a_{out})$$

$$V2' = a_{out}^{10} \times b \times (1 - a_{out})$$

$$VI' = a_{out}{}^{11} \times b \times (1 - a_{out})$$

Thus, in this embodiment, not only the values of the reflectivity $a_{in}$ of the mirrors for in-band light and the values of the reflectivity $a_{out}$ of the mirrors for out-band light but also the value of the reflectivity b of the wafer 7 for out-band light affect the heat-absorption amount equation (10). Consequently, according to this embodiment, fluctuations in the image-forming characteristics can be controlled more accurately.

Note that, the value of the reflectivity b of the wafer 7 is assumed to be temporally unchanged, but may vary according to the kind of the wafer 7. For this reason, it is desirable that the controlling part 9 have the value of "b" in the equations as a variable (parameter). Thus, it is desirable that the projection exposure apparatus of this embodiment have, for example, a user interface function allowing a user to input the value of the reflectivity b. instead of this function, a sensor actually measuring the reflectivity b from the wafer 7 may be provided. The sensor consists of, for example, a light-emitting part emitting out-band light to part of the wafer 7, and a light-receiving part detecting the light quantity of the reflected light. In addition, if an average value (e.g. 0.7) of the reflectivity b is stored as a default value in the controlling part 9 in advance, it is also possible to save labor of the user input or the actual measurement.

Furthermore, this embodiment is a variation of the first embodiment, and the second embodiment or the third embodiment may also be similarly varied.

**Claims**

1. An exposure apparatus exposing an object (7) to be exposed with light emitted from a light source (1a), said exposure apparatus comprising
   a detecting unit (12, 13) adapted to detect light quantity of exposure wavelength component of said light and light quantity of non-exposure wavelength component of said light independently;
   a projection optical system (6) arranged between said light source (1a) and said object (7) to be exposed;
   **characterized by**
   a controlling unit (9) adapted to estimate, based on said light quantity of exposure wavelength component and said light quantity of non-exposure wavelength component, an amount of fluctuation in the image-forming characteristics of the projection optical system (6) caused by irradiation heat of light, and determining adjusting amounts of the projection optical system (6) necessary for controlling the fluctuations in the image-forming characteristics; and
   an adjusting unit (8) adapted to adjust said projection optical system (6) based on the amount of fluctuation in the image-forming characteristics.

2. The exposure apparatus according to claim 1, wherein the controlling unit is adapted for estimating, based on said light quantity of exposure wavelength component and said light quantity of non-exposure wavelength component, a heat-absorption amount of the projection optical system caused by the exposure wavelength component of said light and a heat-absorption amount of the projection optical system caused by the non-exposure wavelength component of said light independently.

3. The exposure apparatus according to claim 1 or claim 2, wherein said projection optical system includes at least one mirror, and wherein the controlling unit is adapted for estimating a heat-absorption amount of the at least one mirror based on the light quantity of exposure wavelength component and the light quantity of non-exposure wavelength component of said light incident on the projection optical system,
   calculating the deformation rate of the at least one mirror based on the heat absorption amount of the mirror and a history of the heat-absorption amount,
   determining an adjusting amount of the at least one mirror based on the deformation rate of the at least one mirror.

4. The exposure apparatus according to any one of claims 1 to 3, wherein:

   said projection optical system includes at least one mirror; and
   at least one of subjects to be adjusted by said adjusting unit is a position of said mirror in a direction perpendicular to an optical axis.

5. The exposure apparatus according to any one of claims 1 to 4, wherein:

   said projection optical system includes at least one mirror; and

at least one of the subjects to be adjusted by said adjusting unit is an attitude of said mirror.

6. The exposure apparatus according to any one of claims 1 to 5, wherein:

said projection optical system is adapted to project a pattern of a mask arranged on said light source's side onto said object to be exposed; and
at least one of the subjects to be adjusted by said adjusting unit is a relative position between said mask and said object to be exposed.

7. The exposure apparatus according to any one of claims 1 to 6, wherein:

said projection optical system is adapted to project a pattern of a mask arranged on said light source's side onto said object to be exposed; and
at least one of the subjects to be adjusted by said adjusting unit is an attitude of at least one of said mask and said object to be exposed.

8. The exposure apparatus according to any one of claims 3 to 7, wherein:

said adjusting unit is adapted to determine, to carry out said adjusting, adjustment contents of said projection optical system based on light quantity of said exposure wavelength component, light quantity of said non-exposure wavelength component, characteristic information of said projection optical system for said exposure wavelength component, and characteristic information of said projection optical system for said non-exposure wavelength component.

9. The exposure apparatus according to claim 8, wherein,
said detecting unit includes at least two of the detecting units, which are a first detecting unit whose detecting object is light before passing said projection optical system, and a second detecting unit whose detecting object is light after passing said projection optical system; and wherein said adjusting unit is adapted to :

correct characteristic information of said projection optical system for said exposure wavelength component based on light quantity of said exposure wavelength component detected by said first detecting unit and light quantity of said exposure wavelength component detected by said second detecting unit; and
correct characteristic information of said projection optical system for said non-exposure wavelength component based on light quantity of said non-exposure wavelength component detected by said first detecting unit and light quantity of said non-exposure wavelength component detected by said second detecting unit.

10. The exposure apparatus according to claim 8 or 9, wherein characteristic information of said projection optical system includes each of absorption coefficients of optical members in said projection optical system.

11. The exposure apparatus according to any one of claims 8 to 10, wherein said adjusting unit is adapted to reflect information about reflectivity of said object to be exposed for said non-exposure wavelength component in said adjustment contents.

12. The exposure apparatus according to claim 11, further comprising a detecting unit detecting reflectivity of said object to be exposed for said non-exposure wavelength component.

13. The exposure apparatus according to any one of claims 1 to 12, wherein said detecting unit comprises:

a sensor for exposure wavelength is adapted to detect light quantity of exposure wavelength component of said light; and
a sensor for non-exposure wavelength adapted to detect light quantity of non-exposure wavelength component of said light.

14. The exposure apparatus according to any one of claims 1 to 12, wherein said detecting unit includes:

a sensor for specific wavelength is adapted to detect one of light quantity of exposure wavelength component and light quantity of non-exposure wavelength component of said light; and
a sensor for all wavelengths is adapted to detect light quantity of all wavelength components of said light.

**15.** The exposure apparatus according to any one of claims 1 to 12, wherein said detecting unit includes:

a sensor for all wavelengths adapted to detect light quantity of all wavelength components of said light; and a switching unit adapted to switch wavelength of an incident light on said sensor for all wavelengths between at least two of exposure wavelength, non-exposure wavelength, and all wavelengths.

**16.** The exposure apparatus according to any one of claims 1 to 15, wherein said light source is an EUV light source.

**17.** A method of adjusting a projection optical system (6), the method comprising:

calculating a light quantity of exposure wavelength component and a light quantity of non-exposure wavelength component of light incident on the projection optical system (6) independently; estimating, based on said light quantity of exposure wavelength component and said light quantity of non-exposure wavelength component, an amount of fluctuation in the image-forming characteristics of the projection optical system (6) caused by irradiation heat of light; determining adjusting amounts of the projection optical system (6) based on the calculated light quantities.

**18.** The method of claim 17, further comprising:

giving an instruction for adjustment and adjusting amounts to an adjustment unit to adjust the projection optical system.

**19.** The method of claim 18, wherein said projection optical system includes at least one mirror, the method further comprising:

giving an instruction for adjustment and adjusting amounts to a mirror adjusting mechanism to adjust the projection optical system.

**Patentansprüche**

**1.** Eine Belichtungsvorrichtung, die ein zu belichtendes Objekt (7) mit aus einer Lichtquelle (1a) emittiertem Licht belichtet, wobei die Belichtungsvorrichtung aufweist:

eine Detektionseinheit (12, 13), die angepasst ist, um die Lichtmenge der Belichtungswellenlängen-Komponente des Lichtes und die Lichtmenge der Nicht-Belichtungswellenlängen-Komponente des Lichtes unabhängig voneinander zu detektieren, ein optisches Projektionssystem (6), das zwischen der Lichtquelle (la) und dem zu belichtenden Objekt (7) angeordnet ist, **gekennzeichnet durch** eine Steuereinheit (9), die angepasst ist, um auf der Grundlage der Lichtmenge der Belichtungswellenlängen-Komponente und der Lichtmenge der Nicht-Belichtungswellenlängen-Komponente einen **durch** Strahlungswärme von Licht bewirkten Schwankungsbetrag für die Bilderzeugungseigenschaften des optischen Projektionssystems (6) zu schätzen und Einstellungsbeträge des optischen Projektionssystems (6), die zum Steuern der Schwankungen bei den Bilderzeugungseigenschaften erforderlich sind, zu bestimmen, und eine Einstellungseinheit (8), die angepasst ist, um das optische Projektionssystem (6) auf der Grundlage des Schwankungsbetrags bei den bilderzeugenden Eigenschaften einzustellen.

**2.** Die Belichtungsvorrichtung gemäß Anspruch 1, wobei die Steuereinheit angepasst ist, um auf der Grundlage der Lichtmenge der Belichtungswellenlängen-Komponente und der Lichtmenge der Nicht-Belichtungswellenlängen-Komponente einen Wärmeabsorptionsbetrag des optischen Projektionssystems, der durch die Belichtungswellenlängen-Komponente des Lichtes bewirkt wird, und einen Wärmeabsorptionsbetrag des optischen Projektionssystems, der durch die Nicht-Belichtungswellenlängen-Komponente des Lichtes bewirkt wird, unabhängig voneinander zu schätzen.

**3.** Die Belichtungsvorrichtung gemäß Anspruch 1 oder Anspruch 2, wobei das optische Projektionssystem mindestens einen Spiegel aufweist, und wobei die Steuereinheit angepasst ist, um:

einen Wärmeabsorptionsbetrag des mindestens einen Spiegels auf der Grundlage der Lichtmenge der Belichtungswellenlängen-Komponente und der Lichtmenge der Nicht-Belichtungswellenlängen-Komponente des auf das optische Projektionssystem einfallenden Lichts zu schätzen,
die Verformungsrate des mindestens einen Spiegels auf der Grundlage des Wärmeabsorptionsbetrags des Spiegels und einer Historie des Wärmeabsorptionsbetrags zu berechnen,
einen Einstellungsbetrag des mindestens einen Spiegels auf der Grundlage der Verformungsrate des mindestens einen Spiegels zu bestimmen.

4. Die Belichtungsvorrichtung gemäß irgendeinem der Ansprüche 1 bis 3, wobei:

das optische Projektionssystem mindestens einen Spiegel aufweist, und
mindestens einer von durch die Einstellungseinheit einzustellenden Punkten eine Position des Spiegels in einer Richtung senkrecht zu einer optischen Achse ist.

5. Die Belichtungsvorrichtung gemäß irgendeinem der Ansprüche 1 bis 4, wobei:

das optische Projektionssystem mindestens einen Spiegel aufweist, und
mindestens einer der durch die Einstellungseinheit einzustellenden Punkte eine Stellung des Spiegels ist.

6. Die Belichtungsvorrichtung gemäß irgendeinem der Ansprüche 1 bis 5, wobei
das optische Projektionssystem angepasst ist, um ein Muster einer Maske, die auf der Lichtquellenseite angeordnet ist, auf das zu belichtende Objekt zu projizieren, und
mindestens einer der durch die Einstellungseinheit einzustellenden Punkte eine relative Position zwischen der Maske und dem zu belichtenden Objekt ist.

7. Die Belichtungsvorrichtung gemäß irgendeinem der Ansprüche 1 bis 6, wobei:

das optische Projektionssystem angepasst ist, um ein Muster einer auf der Lichtquellenseite angeordneten Maske auf das zu belichtende Objekt zu projizieren, und
mindestens einer der durch die Einstellungseinheit einzustellenden Punkte eine Stellung von mindestens einem von der Maske und dem zu belichtenden Objekt ist.

8. Die Belichtungsvorrichtung gemäß irgendeinem der Ansprüche 3 bis 7, wobei:

die Einstellungseinheit angepasst ist, um zum Durchführen des Einstellens Einstellungsinhalte des optischen Projektionssystems auf der Grundlage der Lichtmenge der Belichtungswellenlängen-Komponente, der Lichtmenge der Nicht-Belichtungswellenlängen-Komponente, von Merkmalsinformationen des optischen Projektionssystems für die Belichtungswellenlängen-Komponente und Merkmalsinformationen des optischen Projektionssystems für die Nicht-Belichtungswellenlängen-Komponente zu bestimmen.

9. Die Belichtungsvorrichtung gemäß Anspruch 8, wobei die Detektionseinheit mindestens zwei von Detektionseinheiten aufweist, die eine erste Detektionseinheit, deren Detektionsobjekt Licht vor dem Passieren durch das optische Projektionssystem ist, und eine zweite Detektionseinheit sind, deren Detektionsobjekt Licht nach dem Passieren durch das optische Projektionssystem ist, und wobei die Einstellungseinheit angepasst ist, um:

Merkmalsinformationen des optischen Projektionssystems für die Belichtungswellenlängen-Komponente auf der Grundlage der Lichtmenge der Belichtungswellenlängen-Komponente, die durch die erste Detektionseinheit detektiert wird, und der Lichtmenge der Belichtungswellenlängen-Komponente, die durch die zweite Detektionseinheit detektiert wird, zu korrigieren, und
Merkmalsinformationen des optischen Projektionssystems für die Nicht-Belichtungswellenlängen-Komponente auf der Grundlage der Lichtmenge der Nicht-Belichtungswellenlängen-Komponente, die durch die erste Detektionseinheit detektiert wird, und der Lichtmenge der Nicht-Belichtungswellenlängen-Komponente, die durch die zweite Detektionseinheit detektiert wird, zu korrigieren.

10. Die Belichtungsvorrichtung gemäß Anspruch 8 oder 9, wobei die Merkmalsinformationen des optischen Projektionssystems jeden von Absorptionskoeffizienten von optischen Elementen in dem optischen Projektionssystem aufweisen.

**11.** Die Belichtungsvorrichtung gemäß irgendeinem der Ansprüche 8 bis 10, wobei die Einstellungseinheit angepasst ist, um Informationen über das Reflexionsvermögen des zu belichtenden Objekts für die Nicht-Belichtungswellenlängen-Komponente in den Einstellungsinhalten zu reflektieren.

**12.** Die Belichtungsvorrichtung gemäß Anspruch 11, ferner eine Detektionseinheit aufweisend, die das Reflexionsvermögen des zu belichtenden Objekts für die Nicht-Belichtungswellenlängen-Komponente detektiert.

**13.** Die Belichtungsvorrichtung gemäß irgendeinem der Ansprüche 1 bis 12, wobei die Detektionseinheit aufweist:

einen Sensor für die Belichtungswellenlänge, der angepasst ist, um die Lichtmenge der Belichtungswellenlängen-Komponente des Lichtes zu detektieren, und
einen Sensor für die Nicht-Belichtungswellenlänge, der angepasst ist, um die Lichtmenge der Nicht-Belichtungswellenlängen-Komponente des Lichtes zu detektieren.

**14.** Die Belichtungsvorrichtung gemäß irgendeinem der Ansprüche 1 bis 12, wobei die Detektionseinheit aufweist:

einen Sensor für eine spezifische Wellenlänge, der angepasst ist, um eine von der Lichtmenge der Belichtungswellenlängen-Komponente und der Lichtmenge der Nicht-Belichtungswellenlängen-Komponente des Lichtes zu detektieren, und
einen Sensor für alle Wellenlängen, der angepasst ist, um die Lichtmenge aller Wellenlängenkomponenten des Lichtes zu detektieren.

**15.** Die Belichtungsvorrichtung gemäß irgendeinem der Ansprüche 1 bis 12, wobei die Detektionseinheit aufweist:

einen Sensor für alle Wellenlängen, der angepasst ist, um die Lichtmenge aller Wellenlängenkomponenten des Lichts zu detektieren, und
eine Umschalteinheit, die angepasst ist, um die Wellenlänge von einfallendem Licht an dem Sensor für alle Wellenlängen zwischen mindestens zwei von der Belichtungswellenlänge, der Nicht-Belichtungswellenlänge und allen Wellenlängen umzuschalten.

**16.** Die Belichtungsvorrichtung gemäß irgendeinem der Ansprüche 1 bis 15, wobei die Lichtquelle eine EUV-Lichtquelle ist.

**17.** Ein Verfahren zum Einstellen eines optischen Projektionssystems (6), wobei das Verfahren aufweist:

Berechnen einer Lichtmenge der Belichtungswellenlängen-Komponente und einer Lichtmenge der Nicht-Belichtungswellenlängen-Komponente von an dem optischen Projektionssystem (6) einfallendem Licht unabhängig voneinander,
Schätzen, auf der Grundlage der Lichtmenge der Belichtungswellenlängen-Komponente und der Lichtmenge der Nicht-Belichtungswellenlängen-Komponente, eines durch die Strahlungswärme von Licht erzeugten Schwankungsbetrags bei den Bilderzeugungseigenschaften des optischen Projektionssystems (6), und
Bestimmen der Einstellungsbeträge des optischen Projektionssystems (6) auf der Grundlage der berechneten Lichtmengen.

**18.** Das Verfahren gemäß Anspruch 17, ferner aufweisend:

Ausgeben eines Befehls zum Einstellen und für Einstellungsbeträge an eine Einstellungseinheit, um das optische Projektionssystem einzustellen.

**19.** Das Verfahren gemäß Anspruch 18, wobei das optische Projektionssystem mindestens einen Spiegel aufweist, wobei das Verfahren ferner aufweist:

Ausgeben eines Befehls zum Einstellen und für Einstellungsbeträge an einen Spiegel-Einstellungs-Mechanismus, um das optische Projektionssystem einzustellen.

**Revendications**

1. Appareil d'exposition qui expose un objet (7) à exposer avec une lumière émise par une source de lumière (la), ledit appareil d'exposition comprenant :

une unité de détection (12, 13) adaptée de façon à détecter de manière indépendante la quantité de lumière de la composante de longueur d'onde d'exposition de ladite lumière et la quantité de lumière de la composante de longueur d'onde de non exposition de ladite lumière ;
un système optique de projection (6) agencé entre ladite source de lumière (la) et ledit objet (7) à exposer ;
**caractérisé par** :

une unité de commande (9) adaptée de façon à estimer, sur la base de ladite quantité de lumière de la composante de longueur d'onde d'exposition et de ladite quantité de lumière de la composante de longueur d'onde de non exposition, une quantité de fluctuation dans les caractéristiques de formation d'image du système optique de projection (6) provoquée par la chaleur d'irradiation de la lumière, et à déterminer des quantités de réglage du système optique de projection (6) nécessaires pour contrôler les fluctuations dans les caractéristiques de formation d'image ; et
une unité de réglage (8) adaptée de façon à régler ledit système optique de projection (6) sur la base de la quantité de fluctuation dans les caractéristiques de formation d'image.

2. Appareil d'exposition selon la revendication 1, dans lequel l'unité de commande est adaptée de façon à estimer de manière indépendante, sur la base de ladite quantité de lumière de la composante de longueur d'onde d'exposition et de ladite quantité de lumière de la composante de longueur d'onde de non exposition, la quantité d'absorption de la chaleur du système optique de projection provoquée par la composante de longueur d'onde d'exposition de ladite lumière et la quantité d'absorption de la chaleur du système optique de projection provoquée par la composante de longueur d'onde de non exposition de ladite lumière.

3. Appareil d'exposition selon la revendication 1 ou la revendication 2, dans lequel ledit système optique de projection comprend au moins un miroir, et dans lequel l'unité de commande est adaptée de façon à :

estimer la quantité d'absorption de la chaleur du ou des miroirs sur la base de la quantité de lumière de la composante de longueur d'onde d'exposition et de la quantité de lumière de la composante de longueur d'onde de non exposition de ladite lumière incidente sur le système optique de projection ;
calculer le taux de déformation du ou des miroirs sur la base de la quantité d'absorption de la chaleur du miroir et d'un historique de la quantité d'absorption de la chaleur ;
déterminer la quantité de réglage du ou des miroirs sur la base du taux de déformation du ou des miroirs.

4. Appareil d'exposition selon l'une quelconque des revendications 1 à 3, dans lequel :

ledit système optique de projection comprend au moins un miroir ; et
l'un au moins des sujets à régler par ladite unité de réglage est la position dudit miroir dans une direction perpendiculaire à un axe optique.

5. Appareil d'exposition selon l'une quelconque des revendications 1 à 4, dans lequel :

ledit système optique de projection comprend au moins un miroir ; et
l'un au moins des sujets à régler par ladite unité de réglage est l'orientation dudit miroir.

6. Appareil d'exposition selon l'une quelconque des revendications 1 à 5, dans lequel :

ledit système optique de projection est adapté de façon à projeter un motif d'un masque agencé sur un côté de ladite source de lumière, sur ledit objet à exposer ; et
l'un au moins des sujets à régler par ladite unité de réglage est la position relative entre ledit masque et ledit objet à exposer.

7. Appareil d'exposition selon l'une quelconque des revendications 1 à 6, dans lequel :

ledit système optique de projection est adapté de façon à projeter un motif d'un masque agencé sur un côté de ladite source de lumière, sur ledit objet à exposer ; et

l'un au moins des sujets à régler par ladite unité de réglage est l'orientation dudit masque et / ou dudit objet à exposer.

**8.** Appareil d'exposition selon l'une quelconque des revendications 3 à 7, dans lequel :

ladite unité de réglage est adaptée de façon à déterminer, afin de procéder audit réglage, un contenu de réglage dudit système optique de projection sur la base de la quantité de lumière de ladite composante de longueur d'onde d'exposition, de la quantité de lumière de ladite composante de longueur d'onde de non exposition, des informations caractéristiques dudit système optique de projection pour ladite composante de longueur d'onde d'exposition, et des informations caractéristiques dudit système optique de projection pour ladite composante de longueur d'onde de non exposition.

**9.** Appareil d'exposition selon la revendication 8, dans lequel :

ladite unité de détection comprend au moins deux unités de détection, qui sont une première unité de détection dont l'objet de la détection est la lumière avant son passage dans ledit système optique de projection, et une deuxième unité de détection dont l'objet de la détection est la lumière après son passage dans ledit système optique de projection ;

et dans lequel ladite unité de réglage est adaptée de façon à :

corriger les informations caractéristiques dudit système optique de projection pour ladite composante de longueur d'onde d'exposition sur la base de la quantité de lumière de ladite composante de longueur d'onde d'exposition détectée par ladite première unité de détection et de la quantité de lumière de ladite composante de longueur d'onde d'exposition détectée par ladite deuxième unité de détection ; et

corriger les informations caractéristiques dudit système optique de projection pour ladite composante de longueur d'onde de non exposition sur la base de la quantité de lumière de ladite composante de longueur d'onde de non exposition détectée par ladite première unité de détection et de la quantité de lumière de ladite composante de longueur d'onde de non exposition détectée par ladite deuxième unité de détection.

**10.** Appareil d'exposition selon la revendication 8 ou la revendication 9, dans lequel les informations caractéristiques dudit système optique de projection comprennent chacun des coefficients d'absorption des éléments optiques dans ledit système optique de projection.

**11.** Appareil d'exposition selon l'une quelconque des revendications 8 à 10, dans lequel ladite unité de réglage est adaptée de façon à refléter des informations qui se rapportent à la réflectivité dudit objet à exposer pour ladite composante de longueur d'onde de non exposition dans ledit contenu de réglage.

**12.** Appareil d'exposition selon la revendication 11, comprenant en outre une unité de détection qui détecte la réflectivité dudit objet à exposer pour ladite composante de longueur d'onde de non exposition.

**13.** Appareil d'exposition selon l'une quelconque des revendications 1 à 12, dans lequel ladite unité de détection comprend :

un détecteur de longueur d'onde d'exposition adapté de façon à détecter la quantité de lumière de la composante de longueur d'onde d'exposition de ladite lumière ; et

un détecteur de longueur d'onde de non exposition adapté de façon à détecter la quantité de lumière de la composante de longueur d'onde de non exposition de ladite lumière.

**14.** Appareil d'exposition selon l'une quelconque des revendications 1 à 12, dans lequel ladite unité de détection comprend :

un détecteur d'une longueur d'onde spécifique adapté de façon à détecter la quantité de lumière de la composante de longueur d'onde d'exposition ou la quantité de lumière de la composante de longueur d'onde de non exposition de ladite lumière ; et

un détecteur de toutes les longueurs d'ondes adapté de façon à détecter la quantité de lumière de toutes les composantes de longueurs d'ondes de ladite lumière.

**15.** Appareil d'exposition selon l'une quelconque des revendications 1 à 12, dans lequel ladite unité de détection comprend :

un détecteur de toutes les longueurs d'ondes adapté de façon à détecter la quantité de lumière de toutes les composantes de longueurs d'ondes de ladite lumière ; et
une unité de commutation adaptée de façon à commuter la longueur d'onde d'une lumière incidente sur ledit détecteur pour toutes les longueurs d'ondes entre au moins deux d'une longueur d'onde d'exposition, d'une longueur d'onde de non exposition, et de toutes les longueurs d'onde.

**16.** Appareil d'exposition selon l'une quelconque des revendications 1 à 15, dans lequel ladite source de lumière est une source de lumière EUV.

**17.** Procédé de réglage d'un système optique de projection (6), le procédé comprenant les étapes consistant à :

calculer de manière indépendante une quantité de lumière de la composante de longueur d'onde d'exposition et la quantité de lumière de la composante de longueur d'onde de non exposition d'une lumière incidente sur le système optique de projection (6) ;
estimer, sur la base de ladite quantité de lumière de la composante de longueur d'onde d'exposition et de ladite quantité de lumière de la composante de longueur d'onde de non exposition, une quantité de fluctuation dans les caractéristiques de formation d'image du système optique de projection (6) provoquée par la chaleur d'irradiation de la lumière ;
déterminer des quantités de réglage du système optique de projection (6) sur la base des quantités de lumière calculées.

**18.** Procédé selon la revendication 17, comprenant en outre une étape consistant à :

fournir une instruction de réglage et des quantités de réglage à une unité de réglage de façon à régler le système optique de projection.

**19.** Procédé selon la revendication 18, dans lequel ledit système optique de projection comprend au moins un miroir, le procédé comprenant en outre une étape consistant à :

fournir une instruction de réglage et des quantités de réglage à un mécanisme de réglage de miroir de façon à régler le système optique de projection.

[Fig.1]

[Fig.2

[Fig.3]

(a)

(b)

WAVELENGTH

[Fig.4]

START

REFER TO OUTPUTS OF TWO LIGHT QUANTITY SENSORS | S1

CALCULATE LIGHT QUANTITIES OF in-band LIGHT AND out-band LIGHT INDEPENDENTLY | S2

DETERMINE ADJUSTING AMOUNT OF PROJECTION OPTICAL SYSTEM | S3

ADJUST BY GIVING INSTRUCTION TO ADJUSTING MECHANISM | S4

[Fig.5]

(a)

12

F        SA

in-band ——A——→ [ P ] ——→ [ S T ] ——X——

out-band ——B——→

(b)

13

SA

in-band ——A——————————→ [ S T ] ——Y——

out-band ——B——————————→

TO CONTROLLING PART 9

(c)

5

[ G(R)  H(R) ]

A  B        C  D

in-band

out-band

TO
PROJECTION OPTICAL SYSTEM 6

[Fig.6]

[Fig.7]

[Fig.8]

[Fig.9]

[Fig.10]

[Fig.11]

[Fig.12]

[Fig.13]

(A)

P1,P2,P3,P4,P5,P6

$\downarrow$ M1

$X_1,Y_1,Z_1,\theta_{X1},\theta_{Y1},\theta_{Z1},\cdots,X_6,Y_6,Z_6,\theta_{X6},\theta_{Y6},\theta_{Z6},$

$X_1,Y_1,Z_1,\theta_{X1},\theta_{Y1},\theta_{Z1},\cdots,X_6,Y_6,Z_6,\theta_{X6},\theta_{Y6},\theta_{Z6}$

(B)

$\downarrow$ M2

$X_W,Y_W,Z_W$

[Fig.14]

(A)

in-band
C

out-band
D

M2

E2 V2

M6

E6 V6

M4

E4 V4

E1 V1 — M1

E5 V5

E3 V3 — M3

M5

TO
WAFER

(B)

M2

V2'

M6

V6'

M4

V4'

V1' — M1

out-band

V5'

V3' — M3

M5

7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI936018 B
- JP HEIL116816 B
- US 20020041368 A1